# EUROPÄISCHE PATENTANMELDUNG

(11) **EP 3 525 026 A1**
(43) Veröffentlichungstag der Anmeldung: **14.08.2019**
(21) Anmeldenummer: 18155926.1
(22) Anmeldetag: 09.02.2018
(51) Int. Cl.: G02B 7/04

(54) **OPTOELEKTRONISCHER SENSOR UND VERFAHREN ZUR FOKUSVERSTELLUNG**

(71) Anmelder: Sick AG, 79183 Waldkirch (DE)
(72) Erfinder: Schneider, Florian, 79276 Reute (DE); Pontiggia, Tobias, 79215 Elzach (DE); Pfrengle, Thomas, 79258 Hartheim (DE)

(57) **Zusammenfassung**

Es wird ein optoelektronischer Sensor (10) mit einer fokusverstellbaren Optik (14, 30) angegeben, wobei der Sensor (10) ein bewegliches Trägerelement (22) mit der Optik (14, 30) und ein feststehendes Halteelement (24) aufweist und wobei für eine Einstellung einer Fokuslage die Position des beweglichen Trägerelements (22) gegenüber dem Halteelement (24) veränderbar ist. Dabei ist mindestens eine gerollte Blattfeder (26) zwischen Trägerelement (22) und Halteelement (24) angeordnet.

## Beschreibung

Die Erfindung betrifft einen optoelektronischen Sensor und ein Verfahren zur Fokusverstellung nach dem Oberbegriff von Anspruch 1 beziehungsweise 15.

Die Fokussierung oder umgangssprachlich das Scharfstellen einer Optik ist eine Aufgabenstellung, die sich für eine sehr große Gruppe von optoelektronischen Sensoren stellt. Das betrifft sowohl die Sendeseite, wenn ein Lichtstrahl ausgesandt oder ein Lichtmuster projiziert werden soll, als auch die Empfangsseite für die Erfassung von Lichtstrahlen oder sogar Bildern. In dieser Beschreibung werden als Beispiele für eine sendeseitige Fokussierung ein Barcodescanner mit fokussiertem Lesestrahl und für eine empfangsseitige Fokussierung eine Kamera zur fokussierten Aufnahme von Bildern herangezogen, ohne damit andere optoelektronische Sensoren mit Fokusverstellung auszuschließen. Wie das Beispiel einer 3D-Kamera mit projiziertem Beleuchtungsmuster zeigt, besteht auch Bedarf an sowohl sende- wie empfangsseitiger Fokussierung.

Kameras werden unter anderem in industriellen Anwendungen in vielfältiger Weise eingesetzt, um Objekteigenschaften automatisch zu erfassen, beispielsweise zur Inspektion oder Vermessung von Objekten. Dabei werden Bilder des Objekts aufgenommen und entsprechend der Aufgabe durch Bildverarbeitungsverfahren ausgewertet. Eine weitere Anwendung von Kameras ist das Lesen von Codes. Mit Hilfe eines Bildsensors werden Objekte mit den darauf befindlichen Codes aufgenommen, in den Bildern die Codebereiche identifiziert und dann dekodiert. Kamerabasierte Codeleser kommen problemlos auch mit anderen Codearten als eindimensionalen Strichcodes zurecht, die wie ein Matrixcode auch zweidimensional aufgebaut sind und mehr Informationen zur Verfügung stellen. Auch die automatische Texterfassung von gedruckten Adressen (OCR, Optical Character Recognition) oder Handschriften ist im Prinzip ein Lesen von Codes. Trotz dieser größeren Vielfalt bei kamerabasierten Codelesern sind weiterhin verbreitet die spezialisierten, dafür in der Regel bei gleicher Leseleistung preiswerteren Barcodescanner im Einsatz. Typische Anwendungsgebiete von Codelesern sind Supermarktkassen, die automatische Paketidentifikation, Sortierung von Postsendungen, die Gepäckabfertigung in Flughäfen und andere Logistikanwendungen.

Eine häufige Erfassungssituation ist die Montage eines Codelesers oder einer Kamera für Inspektions- oder Vermessungsaufgaben über einem Förderband. Die Kamera nimmt während der Relativbewegung des Objektstroms auf dem Förderband Bilder auf und speichert die erfassten Informationen beziehungsweise leitet in Abhängigkeit der gewonnenen Objekteigenschaften weitere Bearbeitungsschritte ein. Solche Bearbeitungsschritte können in der an das konkrete Objekt angepassten Weiterverarbeitung an einer Maschine bestehen, die auf geförderte Objekte einwirkt, oder in einer Veränderung des Objektstroms, indem bestimmte Objekte im Rahmen einer Qualitätskontrolle aus dem Objektstrom ausgeschleust werden oder der Objektstrom in mehrere Teilobjektströme sortiert wird. Von einem Codeleser werden die Objekte für eine korrekte Sortierung oder ähnliche Bearbeitungsschritte anhand der angebrachten Codes identifiziert.

Um mit verschiedenen Arbeitsabständen umzugehen und insbesondere Codes in unterschiedlichen Abständen lesen zu können, muss die Fokusposition eingestellt werden. Dafür gibt es unterschiedliche Technologien. Typischerweise wird die Position des Objektivs verändert, also der Abstand zwischen Objektiv und Bildsensor, um eine Umfokussierung zu erzielen. Oftmals geschieht dies automatisch mit Hilfe eines Schrittmotors oder einer Tauchspule.

Die EP 2 498 113 A1 schlägt für einen kamerabasierten Codeleser eine Fokusverstellung mit Hilfe einer motorgetriebenen Kurvenscheibe und einer Parallelführung des Objektivs in einer Federlagerung vor, die mehrere flache Blattfedern aufweist. Die Parallelführung jedoch ist aufwändig und benötigt außerdem viel Bauraum.

Die DE 10 2016 112 123 A1 offenbart einen Barcodescanner mit einer Sendeoptik auf einem Schwenkarm, der zum Fokussieren des Lesestrahls mit einer Tauchspulaktorik verschwenkt wird. Auch das beansprucht recht viel Bauraum. Zudem kommt es durch die Kreisbewegung des Schwenkarms zu einem Versatz zwischen Sendeoptik und Lichtsender.

Die EP 757 270 B1 befasst sich mit einer Autofokusvorrichtung, bei der sich ein Linsenträger mit Linsen elastisch axial in einer mechanischen Führung aus zwei Blattfederblenden bewegt, die parallel zueinander und senkrecht zur optischen Achse der Linsen angeordnet sind. Die Führungs- und Kraftverteilungseigenschaften dieser Anordnung sind aber mit einer Parallelführung wie in EP 2 498 113 A1 nicht vergleichbar.

In der US2016/0178923 A1 wird ein Autofokus-Linsenhalter ebenfalls zwischen zwei Blattfedern gehalten, die eine zentrale Öffnung für den längs der optischen Achse beweglichen Linsenhalter aufweisen. Die Fokusverstellung hat jedoch insgesamt einen komplexen und baugroßen Aufbau.

Es ist daher Aufgabe der Erfindung, eine verbesserte Fokusverstellung anzugeben.

Diese Aufgabe wird durch einen optoelektronischen Sensor und ein Verfahren zur Fokusverstellung nach Anspruch 1 beziehungsweise 15 gelöst. Der Sensor umfasst eine Optik und eine Fokusverstellung dafür. Dazu befindet sich die Optik auf einem beweglichen Trägerelement. Für eine Einstellung einer Fokuslage wird die Position des beweglichen Trägerelements gegenüber einem feststehenden Halteelement verändert.

Die Erfindung geht von dem Grundgedanken einer verbesserten Aufhängung des Trägerelements aus, die auf einer gerollten Blattfeder basiert. Diese gerollte Blattfeder ist zwischen Trägerelement und Halteelement angeordnet.

Die Erfindung hat den Vorteil, dass eine kompakte mechanische Aufhängung mit großen, skalierbaren Stellwegen erreicht wird. Durch die Verwendung von Metallbauteilen und Verformungen der Blattfeder im elastischen Bereich ergibt sich eine hohe Langzeitstabilität.

Das Trägerelement ist bevorzugt mittels der gerollten Blattfeder linear längs der optischen Achse der Optik beweglich gelagert. In der Verlängerung der optischen Achse befindet sich vorzugsweise ein Lichtsender oder Lichtempfänger. Die lineare Bewegung verändert dann den Abstand von Lichtsender oder Lichtempfänger zu der Optik und damit die Fokuslage.

Die gerollte Blattfeder bildet bevorzugt einen Ring. Die Blattfeder ist dazu zusammengerollt und an ihren Enden geschlossen. Ein gewisser Überstand ist vorstellbar, solange dadurch die erforderlichen elastischen Eigenschaften nicht beeinträchtigt sind. Der Begriff Ring ist zunächst topologisch gemeint. Die Form des Rings ähnelt eher einer Ellipse als einem Kreis, wobei die Seiten der Ellipse je nach dort anliegender Kontur verformt sind. Denn im Kontaktbereich zu Trägerelement und Halteelement folgt die gerollte Blattfeder der dort vorgegebenen Kontur, und zwar über einen gewissen Umfangsbereich, der für ausreichend Stabilität sorgt.

Das Trägerelement ist bevorzugt in einer Richtung in der Ebene des Rings beweglich. Die Bewegung während einer Fokuseinstellung erfolgt also nicht quer oder gar senkrecht zu dem Ring. Die gegenseitige Ausrichtung von Trägerelement und Blattfeder kann auch so ausgedrückt werden, dass ein Durchmesser des Rings parallel zur optischen Achse ausgerichtet ist, und zwar vorzugsweise der längste Durchmesser entsprechend der im vorigen Absatz erläuterten groben Ellipsenform.

Die gerollte Blattfeder ist bevorzugt an dem Trägerelement und dem Halteelement fixiert. Damit wird verhindert, dass die gerollte Blattfeder bei einer Einstellung einer Fokuslage relativ zu Trägerelement oder Halteelement verrutscht. Vorzugsweise ist jeweils genau ein Fixierungspunkt vorgesehen. Das genügt einerseits für eine Fixierung und ermöglicht andererseits eine Bewegung über große Verstellwege und ohne unnötigen Widerstand.

Die gerollte Blattfeder ist bevorzugt mit ihrer flachen Außenseite an Halteelement und Trägerelement gedrückt. Der Kontakt zwischen gerollter Blattfeder Halte- und Trägerelement ist also flächig, nicht etwa nur über eine Kante der gerollten Blattfeder. Das sorgt für eine verlässliche Führung und Verstellung, die dann auch gehalten wird.

Die gerollte Blattfeder ist bevorzugt zwischen Halteelement und Trägerelement eingeklemmt. Die gerollte Blattfeder wird somit gleichsam von beiden Seiten eingerahmt und zumindest etwas zusammengedrückt. Die entsprechenden Außenflächen der Blattfeder liegen an Halteelement und Trägerelement an. Träger- und Halteelement verformen die dazwischenliegende gerollte Blattfeder elastisch.

Das Trägerelement und das Halteelement weisen jeweils eine Fläche auf, die parallel zueinander liegen. In diesem Zusammenhang ist der Begriff parallel aber weit aufzufassen. Zum einen ist ein gewisser Winkel erlaubt und in manchen Ausführungsformen sogar erwünscht. Außerdem sind die Flächen selbst nicht zwingend eben, was dann ebenfalls ein modifiziertes Verständnis von einer parallelen Ausrichtung verlangt. Jedenfalls stoßen die Flächen nicht aneinander und befinden sich an gegenüberliegenden Außenseiten der gerollten Blattfeder.

Die gerollte Blattfeder rollt bevorzugt während einer Bewegung des beweglichen Trägerelements auf den Flächen auf oder ab. Während einer Verstellbewegung der Optik auf dem beweglichen Trägerelement bleibt in der Rollbewegung ein im Wesentlichen gleich langer Abschnitt der flachen Außenseite der Blattfeder im Kontakt mit den einrahmenden Flächen von Trägerelement und Halteelement. Dabei dreht sich die gerollte Blattfeder im Verlauf der Rollbewegung, und der in Kontakt stehende Abschnitt ist entsprechend der Rollbewegung zu jedem Zeitpunkt ein etwas anderer.

Die Fläche weist bevorzugt eine Kontur auf, um die gerollte Blattfeder mit einer Vorspannung zu beaufschlagen. Halteelement und/oder Trägerelement sind also nicht eben und parallel zueinander. Die Kontur, die auch lediglich eine schrägstehende ebene Fläche sein kann, sorgt für eine Einstellung der Federvorspannung per Design der Geometrie. Die gerollte Blattfeder überwindet einige Abschnitte der Flächen leichter als andere, was beispielsweise mit dem lokalen Abstand zwischen den Flächen zusammenhängt, welche die gerollte Blattfeder einspannen. Folglich ist Kraft, die für eine jeweilige Verstellung notwendig ist, in einer durch das Design effektiv als Vorspannung vorgegebenen linearen oder nicht linearen Weise von den einzunehmenden Zwischen- und Endpositionen abhängig.

Die Kontur weist vorzugsweise Rastpositionen auf. Das sind spezielle Formgebungen der Flächen, die einer Verstellung aus der einer Rastposition entsprechenden Fokusstellung in beiden Richtungen eine Vorspannung entgegensetzen. Daher verharrt das Trägerelement und damit die Optik ohne Krafteinwirkung in einer Rastposition. Eine Aktorik muss erst wieder auf das Trägerelement einwirken, wenn eine Fokusverstellung aus der zuvor eingestellten Rastposition gewünscht ist.

Der Sensor weist bevorzugt mindestens zwei Halteelemente und mindestens zwei gerollte Blattfedern auf, wobei die Halteelemente zu mindestens zwei Seiten des beweglichen Trägerelements mit jeweils einer gerollten Blattfeder dazwischen angeordnet sind. Das Trägerelement befindet sich vorzugsweise zentrisch zwischen den Blattfedern. Durch mehrere Halteelemente und Blattfedern wird die Führung des beweglichen Trägerelements verbessert. Anstelle von mehreren Halteelementen kann auch ein Halteelement mit mehreren Flächen verwendet werden, die effektiv wie einzelne Halteelemente wirken.

Das Trägerelement weist bevorzugt eine ringförmige Außenfläche und das Halteelement eine ringförmige Innenfläche auf, wobei das Trägerelement konzentrisch in dem Haltelement angeordnet ist und durch Abrollen der gerollten Blattfeder dazwischen eine Rotationsbewegung ausführt. Das erfindungsgemäße Aufhängungskonzept ist nicht nur auf lineare Bewegungen beschränkt. In der beschriebenen Weise ist auch eine Drehbewegung denkbar. Vorzugsweise werden dabei mindestens zwei gerollte Blattfedern eingesetzt, beispielsweise drei gerollte Blattfedern, um eine gleichmäßige, verlässlich geführte Bewegung bei dennoch möglichst wenig Bauelementen zu erzielen.

Der Sensor umfasst bevorzugt einen Lichtsender, wobei die Optik als eine dem Lichtsender zugeordnete Sendeoptik ausgebildet ist und/oder einen Lichtempfänger, wobei die Optik als eine dem Lichtempfänger zugeordnete Empfangsoptik ausgebildet ist. Der Lichtsender beziehungsweise Lichtempfänger ist vorzugsweise auf der optischen Achse der Optik angeordnet, so dass eine Bewegung des Trägerelements den Abstand dazwischen und damit die Fokuslage verändert. Es ist auch denkbar, dass die Fokuslage des Sensors sowohl sende- wie empfangsseitig verstellbar ist. In koaxialer Anordnung von Lichtsender und Lichtempfänger dient dann die Optik als gemeinsame Sende- und Empfangsoptik. In biaxialer Anordnung ist sowohl denkbar, dass Lichtsender und Lichtempfänger jeweils eine eigene Fokusverstellung mit beweglichem Trägerelement, feststehendem Halteelement und gerollter Blattfeder dazwischen aufweisen, wie dass sich Sende- und Empfangsoptik gemeinsam auf demselben beweglichen Trägerelement befinden und eine Fokusverstellung nur gemeinsam möglich ist.

Das erfindungsgemäße Verfahren kann auf ähnliche Weise weitergebildet werden und zeigt dabei ähnliche Vorteile. Derartige vorteilhafte Merkmale sind beispielhaft, aber nicht abschließend in den sich an die unabhängigen Ansprüche anschließenden Unteransprüchen beschrieben.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine Blockdarstellung einer Kamera mit fokusverstellbarer Empfangsoptik;
- Fig. 2: eine Blockdarstellung eines optoelektronischen Sensors mit Lichtsender und fokusverstellbarer Sendeoptik;
- Fig. 3a-c: schematische Schnittdarstellungen einer Aufhängung für eine Optik auf einem beweglichen Träger zwischen gerollten Blattfedern in verschiedenen Positionen;
- Fig. 4a-b: schematische Schnittdarstellungen einer fokusverstellbaren Empfangsoptik auf Basis der Aufhängung gemäß Figur 3a-c in unterschiedlichen Fokuslagen;
- Fig. 5a-b: schematische Schnittdarstellungen einer Aufhängung mit linear varüerender Vorspannung;
- Fig. 5c: eine schematische Schnittdarstellung einer Aufhängung mit wählbar variierender Vorspannung durch Freiformdesign der Fläche der Halterung;
- Fig. 6a-c: schematische Draufsichten auf eine Aufhängung mit zwei, drei und vier gerollten Blattfedern;
- Fig. 7: eine schematische Schnittansicht einer Aufhängung für eine rotatorische statt einer linearen Bewegung; und
- Fig. 8: eine dreidimensionale Ansicht einer beispielhaften Anwendung eines optoelektronischen Sensors in Montage an einem Förderband.

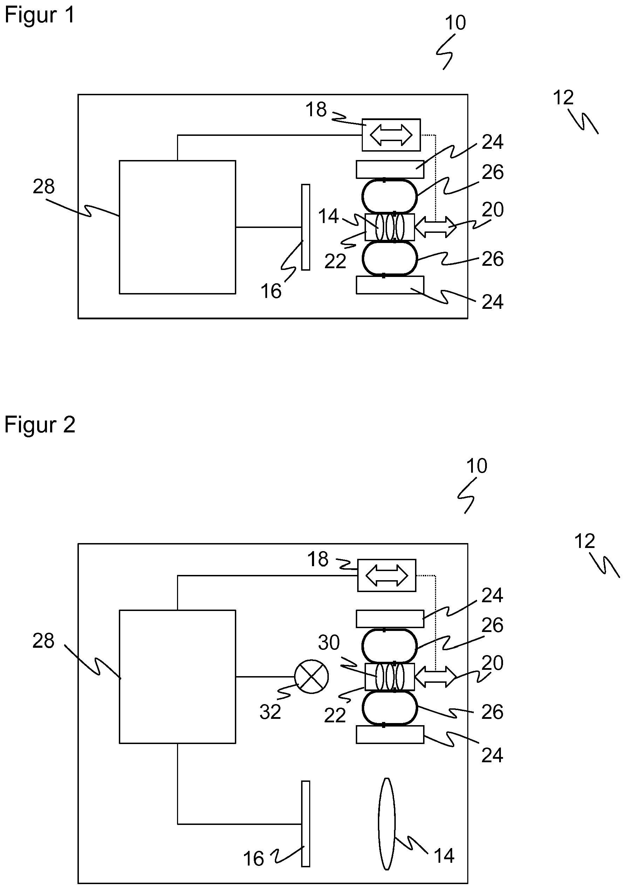

Figur 1 zeigt eine Blockdarstellung einer Kamera als Beispiel eines optoelektronischen Sensors 10 mit empfangsseitiger Fokusverstellung. Empfangslicht aus einem Erfassungsbereich 12 trifft auf eine Empfangsoptik 14, die das Empfangslicht auf einen Lichtempfänger 16 führt. Im Falle einer Kamera ist der Lichtempfänger 16 ein Bildsensor mit einer Vielzahl von Lichtempfangselementen in einer Zeilen- oder Matrixanordnung. Andere Sensoren 10 verwenden eine Photodiode, eine APD (Avalanche Photodiode) oder auch einen SPAD-Empfänger (Single-Photon Avalanche Diode).

Die Empfangsoptik 14 ist hier rein beispielhaft mit drei Linsen dargestellt. Allgemein handelt es sich um ein beliebiges Objektiv aus Linsen und anderen optischen Elementen wie Blenden, Prismen und dergleichen, und im einfachsten Fall um eine Einzellinse.

Um die Fokuslage des Sensors 10 zu verstellen, ist die Empfangsoptik 14 beweglich aufgehängt. Mit Hilfe einer Aktorik 18, beispielsweise einem Schrittmotor oder einer Tauchspulaktorik, wird die Empfangstopitk 14 längs ihrer optischen Achse verschoben, auf der auch der Lichtempfänger 16 angeordnet ist, wie durch einen Pfeil 20 dargestellt. Diese Abstandsänderungen zwischen Empfangsoptik 14 und Lichtempfänger 16 bewirken eine Umfokussierung.

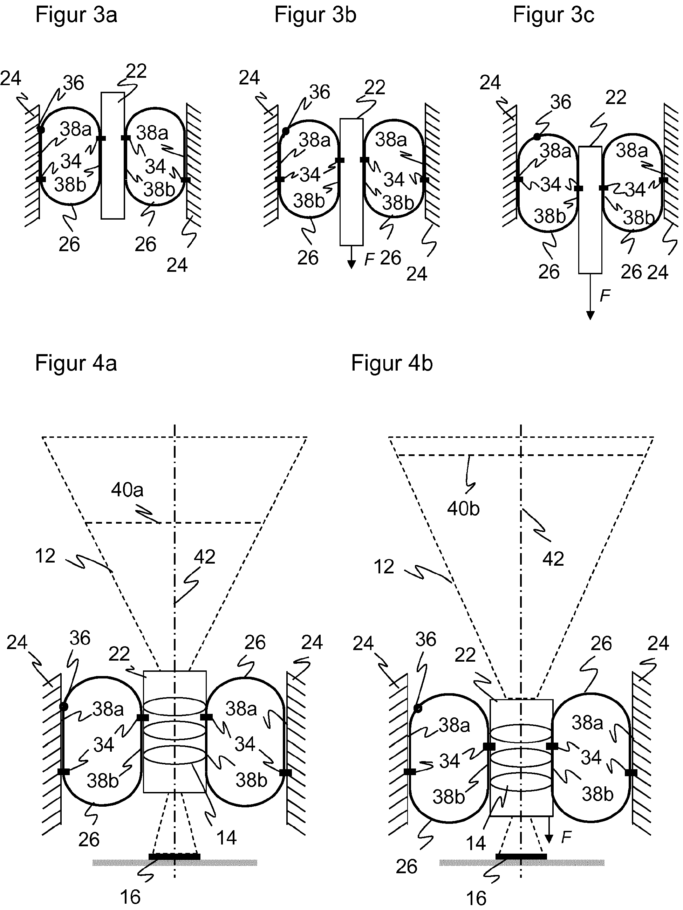

Die Aufhängung umfasst im gezeigten Beispiel ein bewegliches Trägerelement 22 mit der Empfangsoptik 14, ein zweiteiliges, feststehendes Halteelement 24 und zwei gerollte Blattfedern 26 dazwischen. Die Aufhängung und Fokusverstellung sowie Variationen davon werden später unter Bezugnahme auf die Figuren 3 bis 7 genauer erläutert. Angemerkt sei noch, dass die gezeigte Position der Aktorik 18 und der Angriffspunkt des Pfeils 20 nur funktional und nicht geometrisch zu verstehen ist. Um die Lichtwege nicht zu stören, greift die Aktorik 18 vorzugsweise am Umfang des Trägerelements 22 an. Die gerollten Blattfedern 26 lassen insbesondere den Bereich des Trägerelements 22 ober- und unterhalb der Papierebene frei zugänglich.

Eine Steuer- und Auswertungseinheit 28 ist mit dem Lichtempfänger 16 und der Aktorik 18 verbunden. Ein Empfangssignal des Lichtempfängers 16 wird von der Steuer- und Auswertungseinheit 28 ausgelesen und beispielsweise als Bild gespeichert, aufbereitet oder in einem kamerabasierten Codeleser auf Codebereiche untersucht, die dann decodiert werden. Über die Aktorik 18 wird eine jeweils benötigte Fokuslage eingestellt, was auch mit Hilfe eines zusätzlichen, nicht gezeigten Abstandssensors als Autofokus realisierbar ist.

Figur 2 zeigt eine Blockdarstellung eines weiteren Ausführungsbeispiels eines optoelektronischen Sensors 10. Dabei bezeichnen gleiche Bezugszeichen die gleichen oder einander entsprechenden Merkmale, die nicht nochmals beschrieben werden. Im Unterschied zu Figur 1 ist hier eine sendeseitige Fokusverstellung einer Sendeoptik 30 eines Lichtsenders 32 vorgesehen, beispielsweise mit einer LED oder einem Laser als Lichtquelle. Die Empfangsoptik 14 dagegen ist starr. In weiteren Ausführungsformen kann auch die Lage der Empfangsoptik 14 mit der Fokusverstellung verändert werden, die Empfangsoptik 14 eine weitere Fokusverstellung aufweisen oder die Empfangsoptik 14 in einem koaxialen Aufbau als gemeinsame Optik ausgebildet sein, die zugleich als Sendeoptik 30 fungiert.

Die Aufhängung und Veränderung der Fokuslage durch Bewegung der Sendeoptik 30 auf dem Trägerelement 22 erfolgt in gleicher, noch unter Bezugnahme auf die Figuren 3 bis 7 genauer zu erläuternden Weise wie in Figur 1.

Ein Beispiel eines optoelektronischen Sensors 10 mit dem Grundaufbau nach Figur 2 ist ein Barcodescanner. Der Lichtsender 32 erzeugt mittels der Sendeoptik 30 einen Lesestrahl, der nach Reflexion an einem Objekt, insbesondere Codebereich in dem Erfassungsbereich 12 zurückkehrt und über die Empfangsoptik 14 auf den Lichtempfänger 16 geführt wird. Um nicht nur einen Punkt, sondern den ganzen Barcode zu erfassen, erfolgt eine Abtastung mittels eines nicht gezeigten Scanmechanismus' beispielsweise mit einem Schwing- oder Drehspiegel, der den Lesestrahl über den Codebereich bewegt.

Aufgabe der Fokusverstellung ist, den Lesestrahl ausreichend zu fokussieren, so dass die Codeelemente aufgelöst werden. Dazu kann die Einstellung auf einen festen oder parametrierten Abstand genügen. Vorzugsweise wird aber der aktuelle Abstand gemessen. Als vorteilhafte Alternative zu einem zusätzlichen Abstandssensor kann dessen Lesestrahl selbst für eine Entfernungsmessung genutzt werden, indem beispielsweise durch Amplitudenmodulation eine Frequenz auf den Lesestrahl aufgeprägt und der Abstand in einem Phasenverfahren aus dem Phasenversatz zwischen Sende- und Empfangszeitpunkt bestimmt wird.

Bei Abtastung eines Barcodes wird das von dem Lichtempfänger 16 an die Steuer- und Auswertungseinheit 28 geleitete Empfangssignal in den Codebalken entsprechender Weise in seiner Amplitude moduliert. Die Auswertungseinheit 26 ist deshalb in der Lage, die Codeinformation auszulesen. Sie erkennt auch, wenn das Empfangssignal keinem Code entspricht. Das Auffinden von Codebereichen und das Auslesen der Codeinformation ist an sich bekannt und wird daher nicht näher erläutert.

Figur 3a-c zeigen schematische Schnittdarstellungen der Aufhängung für die Fokusverstellung in verschiedenen Auslenkungszuständen durch unterschiedliche Kräfte der Aktorik 18, wie durch mit "F" bezeichnete Pfeile dargestellt. Dabei ist zur übersichtlichen Erläuterung des mechanischen Prinzips die Optik 14, 30 auf dem beweglichen Trägerelement 22 weggelassen.

Das bewegliche Trägerelement 22 ist zu beiden Seiten mittels der beiden gerollten Blattfedern 26 zwischen dem feststehenden Halteelement 24 eingeklemmt. Das bewegliche Trägerelement 22 fungiert als Schwinger, das feststehende Halteelement 24 als Stator. Die gerollten Blattfedern 26 sind an dem beweglichen Trägerelement 22 und dem Halteelement 24 mit jeweils einem Fixierungspunkt 34 befestigt. Die Fixierung ist auch an zusätzlichen Punkten denkbar, was aber den möglichen Verstellweg verkürzt, oder sie kann umgekehrt auch weggelassen werden, da die gerollten Blattfedern 26 mit ihrer Federkraft eingeklemmt sind und die Rollreibung geringer ist als die Haftreibung.

Eine Krafteinwirkung auf das bewegliche Trägerelement 22 in Richtung der Längsachse, die vorzugsweise der optischen Achse der Optik 14, 30 entspricht, bewirkt ein Aufbeziehungsweise Abrollen der gerollten Blattfedern 26. Um die verschiedenen Positionen dieser Rollbewegung in den Figuren 3a-c nachzuvollziehen, ist ein fester Ort auf den gerollten Blattfedern 26 mit einem schwarzen Punkt 36 markiert.

Die gerollten Blattfedern 26 bilden einen Ring, der im Querschnitt zu sehen ist. Durch das Einklemmen zwischen Trägerelement 22 und Halteelement 24 wird der Ring langgestreckt, weicht aber noch von einer Ellipse ab, da sich die seitlichen Bereiche der gerollten Blattfedern 26 an die jeweilige Kontur der Berührungsflächen 38a-b mit dem Trägerelement 22 und dem Halteelement 24 angleichen. Durch die Querschnittsdarstellung sind die gerollten Blattfedern 26 nur als Linie zu sehen. Tatsächlich weist der Ring in Richtung senkrecht zur Papierebene, entsprechend der Natur einer Blattfeder, eine flächige Ausdehnung auf. Die entsprechenden seitlichen Außenflächen sind durch die Federkraft an die Berührungsflächen 38a-b von Trägerelement 22 und Halteelement 24 gedrückt. Aufgrund der Rollbewegung liegt in allen Verstellpositionen die gleiche Länge der gerollten Blattfedern 26 seitlich an Trägerelement 22 und Halteelement 24 an. Die große Berührungsfläche 38a-b bewirkt eine Stabilisierung der Verstellbewegungen und der eingestellten Fokuspositionen. Der Stellweg kann über die Länge des anliegenden Anteils der gerollten Blattfedern 26 beeinflusst werden.

Die Bewegung des Trägerelements 22 erfolgt linear, in der Zeichenebene von oben nach unten, entsprechend der optischen Achse der nicht gezeigten Optik 14, 30. Die Zeichenebene ist zugleich die Ebene des Rings der gerollten Blattfedern 26, in der demzufolge die Bewegung bleibt. Anders ausgedrückt ist die Bewegungsrichtung parallel zu einem Durchmesser des Rings, insbesondere des längsten Durchmessers, der aufgrund des Einklemmens entsteht. Die seitliche Führung ist durch die abrollenden Blattfedern 26 und deren Federkraft gewährleistet. Bei ungleichen gerollten Blattfedern 26 mit unterschiedlicher Federkraft wird der Linearbewegung eine gewisse Rotation überlagert, die Bewegung ist dann nicht mehr streng parallel zum längsten Durchmesser, sondern nur noch tangential zu beiden gerollten Blattfedern 26, was aber im Rahmen der benötigten Stellwege immer noch als parallel aufgefasst werden kann.

Figur 4a-b zeigt eine schematische Schnittdarstellung der fokusverstellbaren Empfangsoptik 14 auf Basis der soeben erläuterten mechanischen Aufhängung für zwei unterschiedliche Fokuslagen 40a-b. In Figur 4a befindet sich das bewegliche Trägerelement 22 ohne Krafteinwirkung der Aktorik 18 in einer Ausgangsposition mit einer ersten Fokuslage 40a. In Figur 4b bewirkt die Aktorik 18 eine Kraft "F" nach unten. Unter Abrollen der gerollten Blattfedern 26 bewegt sich dementsprechend das Trägerelement 22 samt Empfangsoptik 14 längs der optischen Achse 42 nach unten. Der verkürzte Abstand zwischen Empfangsoptik 14 und Lichtempfänger 16 bewirkt eine Verschiebung auf die neue Fokuslage 40b.

Eine Umfokussierung im Sendepfad funktioniert analog, hier wäre lediglich der Lichtempfänger 16 gegen den Lichtsender 32 auszutauschen. Selbstverständlich sind auch die Geometrien, Massen und weiteren optischen und sonstigen Parameter auf die andere Aufgabe einzustellen. Prinzipiell ist denkbar, in einer Umkehrung der Anordnung den Lichtempfänger 16 beziehungsweise den Lichtsender 32 auf dem beweglichen Trägerelement 22 unterzubringen und so deren Position gegenüber einer feststehenden Optik 14, 30 zu variieren. Das bewirkt ebenfalls eine Fokusverstellung, die gezeigte Ausführungsform ist jedoch vorteilhafter, da keine elektrischen Anschlüsse zu einem beweglichen Teil erforderlich sind.

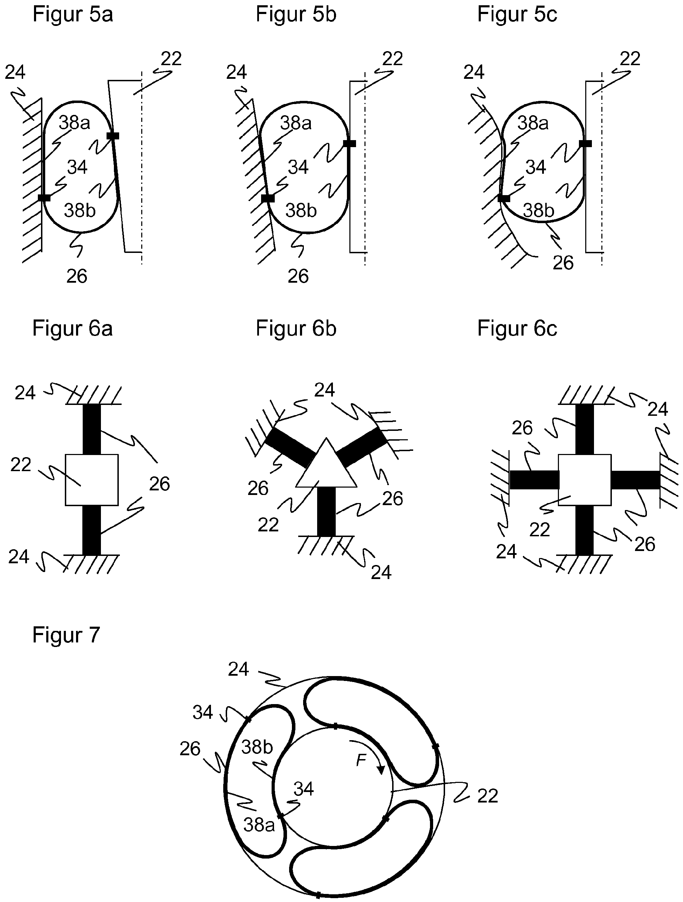

In den bisherigen Ausführungsformen sind die Berührungsflächen 38a-b mit den gerollten Blattfedern 26 von Trägerelement 22 und Halteelement 24 eben und parallel zueinander. Figur 5a-c zeigt einige Beispiele, wie sich durch Design, also alternative besondere Formgebung der Berührungsflächen 38a-b die Vorspannung oder Steifigkeit der Aufhängung für die Fokusverstellung verändern lässt. Generell hängt die Steifigkeit von Materialeigenschaften der gerollten Blattfedern 26 sowie deren Geometrie, also den Biegeradien ab. Die anhand der Figuren 5a-c erläuterten Designvarianten zielen aber nicht auf diese globalen Parameter, sondern lokal unterschiedliche Vorspannungen je Fokusposition.

Die Grundidee ist hier, ortsbezogen den Abstand zwischen Trägerelement 22 und Halteelement 24 zu verändern. Dadurch wird die gerollte Blattfeder 26 mehr oder weniger stark eingeklemmt, es entstehen unterschiedliche Biegeradien, und dementsprechend widersetzt sich die gerollte Blattfeder 26 stärker oder weniger stark einem Rollen in die jeweilige Position

Die Figuren 5a-b zeigen ein Beispiel mit einer linearen Variation der Vorspannung. Durch Schrägstellen zumindest einer der Berührungsflächen 38a-b nimmt der Abstand zwischen Trägerelement 22 und Halteelement 24 linear von oben nach unten längs der optischen Achse zu oder ab. In Figur 5a ist die Berührungsfläche 38b des Trägerelements 22 schräg gestellt, so dass Bewegungen nach unten zunehmend weniger Vorspannung überwinden müssen. In Figur 5b steht alternativ die Berührungsfläche 38a des Halteelements 24 schräg, zudem so, dass nun umgekehrt der Abstand nach unten hin kürzer wird, so dass die Vorspannung bei Bewegungen des Trägerelements 22 nach unten zunimmt. Als weitere Alternative könnten sowohl Trägerelement 22 als auch Halteelement 24 schräggestellte Berührungsflächen 38a-b aufweisen.

Figur 5c zeigt ein Beispiel, in der anstelle einer linearen Variation durch die schrägstellten, aber weiterhin ebene Berührungsflächen 38a-b gemäß Figur 5a-b eine Freiformfläche designt wird. Dadurch entstehen in unterschiedlichen Positionen des Trägerelements 22 unterschiedliche Vorspannungen beziehungsweise Federkonstanten, die durch die Formgebung der Freiformfläche in einem großen Variationsbereich weitgehend frei wählbar sind. Eine Freiformfläche kann dabei von einer schrägstehenden Fläche wie in den Figuren 5a-b ausgehen.

Eine Freiformfläche bietet die vorteilhafte Möglichkeit, gezielt bestimmte Rastpositionen einzubringen. Das sind Fokuslagen, in denen das Trägerelement 22 auch ohne Krafteinwirkung der Aktorik 18 stehen bleibt, so dass die Aktorik 18 jeweils nur vorübergehend tätig werden muss, um in eine Rastposition zu wechseln. Eine Rastposition kann also ohne externe Kraft gehalten werden. Das ist in gewisser Weise schon durch die Haftreibung der gerollten Blattfedern 26 gegeben. Eine Rastposition zeichnet sich dadurch aus, dass in beiden Verstellrichtungen eine Vorspannung überwunden werden muss, um die Rastposition zu verlassen.
Alternativ zu einer Formgebung der Berührungsflächen 38a-b ist auch denkbar, die gerollten Blattfedern 26 selbst gezielt mit unterschiedlichen Eigenschaften je nach Rollposition zu versehen. Das ließe sich durch Material- und Dickenvariationen verwirklichen, die aber einen recht aufwändigen Herstellungsprozess verlangen. Einfacher ist es, die gerollten Blattfedern 26 vor ihrem Einbau gezielt plastisch zu deformieren. Das führt dann zu unterschiedlichen seitlichen Krafteinwirkungen auf das Trägerelement 22 je nach dessen Position.

In den bisher vorgestellten Ausführungsformen umfasst die Aufhängung jeweils zwei gerollte Blattfedern 26. Diese Konstellation ist in Figur 6a nochmals in einer vereinfachten Draufsicht dargestellt, die nur das bewegliche Trägerelement 22, das feststehende Halteelement 24 und die beiden gerollten Blattfedern 26 dazwischen zeigt. Die Anordnung diametral gegenüber, als die Ausrichtung der beiden Blattfedern 26 zueinander mit einem Winkel von 180°, ist besonders vorteilhaft, da es dann keine resultierende Federkraft gibt, welche lateral auf das Trägerelement 22 einwirkt. Aufgrund ihrer Breite könnten die gerollten Blattfedern 26 aber auch eine gewisse Abweichung ausgleichen, zumal wenn zwei gerollte Blattfedern 26 mit unterschiedlichen Eigenschaften eingesetzt werden. Außerdem ist denkbar, einen zusätzlichen Gegenpunkt durch ein weiteres Halteelement gegen die resultierende Kraft zu setzen. Nach diesem Prinzip ist auch möglich, die Aufhängung mit nur einer gerollten Blattfeder 26 zu realisieren, wo dann auf der gegenüberliegenden Seite das weitere Halteelement steht. Beim Auf- und Abrollen der dann einzigen gerollten Blattfeder 26 muss in diesem Fall eine Reibung zwischen der Gegenseite des Trägerelements 22 und dem weiteren Halteelement überwunden werden, die auch durch Hilfsmittel reduziert sein kann, oder das Trägerelement 22 ist dort durch die Reibung oder gezielte Mittel fixiert und dreht sich um das weitere Halteelement.

Die Figuren 6b und 6c zeigen Ausführungsbeispiele für eine Aufhängung mit drei gerollten Blattfedern 26 beziehungsweise vier gerollten Blattfedern 26. Die Aufhängung ist jeweils symmetrisch mit einem zentrisch gelagerten Trägerelement 22, was vorteilhaft, aber nicht zwingend der Fall ist. Die Verwendung von mehr als zwei gerollten Blattfedern 26 kann die Führungseigenschaften und unter anderem die mechanische Stabilität gegenüber externen Einflüssen verbessern. Noch mehr gerollte Blattfedern 26 sind auch möglich.

Bei der Verwendung untereinander gleicher gerollte Blattfedern 26 kommt es zu einer linearen Bewegung des Schwingers aus der Papierebene heraus. Werden unterschiedliche gerollte Blattfedern 26 verwendet, die sich in Parametern wie Geometrie, Vorspannung, Material oder Materialdicke unterscheiden, wird der linearen Bewegung eine Rotation überlagert.

Die bisherigen Aufhängungen sorgen für eine zumindest im Wesentlichen lineare Bewegung des Trägerelements 22. Wie schon ausgeführt, lässt sich eine rotatorische Komponente durch unterschiedliche gerollte Blattfedern 26 erreichen. Eine andere ebenfalls schon angesprochene Möglichkeit besteht darin, das Trägerelement 22 an mindestens eine Seite an einem weiteren Halteelement ohne gerollte Blattfeder 26 dazwischen anzuordnen oder sogar zu fixieren.

Figur 7 zeigt, wie mit dem Konzept eines in gerollten Blattfedern 26 gelagerten beweglichen Trägerelements 22 eine bei Bedarf auch rein rotatorische Bewegung ganz gezielt umgesetzt werden kann. Das Trägerelement 22 weist dafür eine ringförmige Außenfläche als Berührungsfläche 38b, das Halteelement 24 eine entsprechende ringförmige Innenfläche als Berührungsfläche 38a auf. Mehrere gerollte Blattfedern 26 sind über den Umfang des Zwischenraums verteilt. Eine bevorzugte Anordnung sieht eine gleichmäßige Verteilung von drei gerollten Blattfedern 26 vor, aber Anzahl und Verteilung können auch variiert werden.

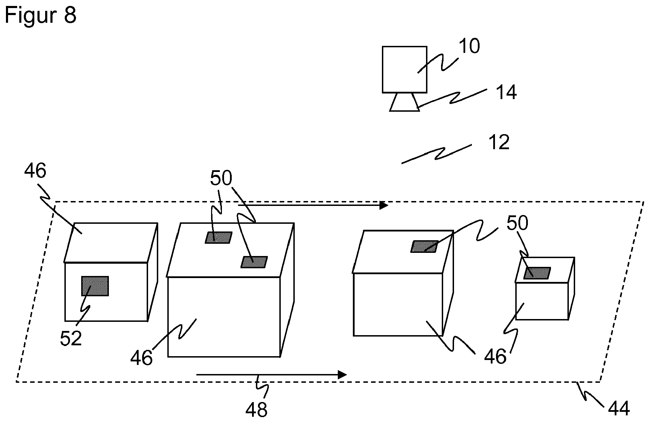

Figur 8 zeigt eine mögliche Anwendung des Sensors 10 in Montage an einem Förderband 44, welches Objekte 46, wie durch den Pfeil 48 angedeutet, durch den Erfassungsbereich 12 des Sensors 10 fördert. Die Objekte 46 können an ihren Außenflächen Codebereiche 50 tragen. Aufgabe des Sensors 10 ist, Eigenschaften der Objekte 46 zu erfassen und in einem bevorzugten Einsatz als Codeleser die Codebereiche 50 zu erkennen, die dort angebrachten Codes auszulesen, zu dekodieren und dem jeweils zugehörigen Objekt 46 zuzuordnen. Um auch seitlich angebrachte Codebereiche 52 zu erkennen, werden vorzugsweise zusätzliche, nicht dargestellte Sensoren 10 aus unterschiedlicher Perspektive eingesetzt.

## Patentansprüche

1. Optoelektronischer Sensor (10) mit einer fokusverstellbaren Optik (14, 30), wobei der Sensor (10) ein bewegliches Trägerelement (22) mit der Optik (14, 30) und ein feststehendes Halteelement (24) aufweist und wobei für eine Einstellung einer Fokuslage die Position des beweglichen Trägerelements (22) gegenüber dem Halteelement (24) veränderbar ist,
**dadurch gekennzeichnet,**
**dass** mindestens eine gerollte Blattfeder (26) zwischen Trägerelement (22) und Halteelement (24) angeordnet ist.

2. Sensor (10) nach Anspruch 1,
wobei das Trägerelement (22) mittels der gerollten Blattfeder (26) linear längs der optischen Achse (42) der Optik (14, 30) beweglich gelagert ist.

3. Sensor (10) nach Anspruch 1 oder 2,
wobei die gerollte Blattfeder (26) einen Ring bildet.

4. Sensor (10) nach Anspruch 3,
wobei das Trägerelement (22) in einer Richtung (20) in der Ebene des Rings beweglich ist.

5. Sensor (10) nach einem der vorhergehenden Ansprüche,
wobei die gerollte Blattfeder (26) an dem Trägerelement (22) und dem Halteelement (26) fixiert (34) ist

6. Sensor (10) nach einem der vorhergehenden Ansprüche,
wobei die gerollte Blattfeder (26) mit ihrer flachen Außenseite an Halteelement (24, 38a) und Trägerelement (22, 38b) gedrückt ist.

7. Sensor (10) nach einem der vorhergehenden Ansprüche,
wobei die gerollte Blattfeder (26) zwischen Halteelement (24, 38a) und Trägerelement (22, 38b) eingeklemmt ist.

8. Sensor (10) nach einem der vorhergehenden Ansprüche,
wobei das Trägerelement (22) und das Halteelement (249 jeweils eine Fläche (38a-b) aufweisen, die parallel zueinander liegen.

9. Sensor (10) nach Anspruch 8,
wobei die gerollte Blattfeder (26) während einer Bewegung des beweglichen Trägerelements (22) auf den Flächen (38a-b) auf- oder abrollt.

10. Sensor (10) nach Anspruch 8 oder 9,
wobei die Flächen (38a-b) eine Kontur aufweisen, um die gerollte Blattfeder (26) mit einer Vorspannung zu beaufschlagen.

11. Sensor (10) nach Anspruch 10,
wobei die Kontur Rastpositionen aufweist.

12. Sensor (10) nach einem der vorhergehenden Ansprüche,
der mindestens zwei Halteelemente (24) und mindestens zwei gerollte Blattfedern (26) aufweist, wobei die Halteelemente (24) zu mindestens zwei Seiten des beweglichen Trägerelements (22) mit jeweils einer gerollten Blattfeder (26) dazwischen angeordnet sind.

13. Sensor (10) nach einem der vorhergehenden Ansprüche,
wobei das Trägerelement (22) eine ringförmige Außenfläche (38b) und das Halteelement (24) eine ringförmige Innenfläche (38a) aufweist, das Trägerelement (22) konzentrisch in dem Haltelement (24) angeordnet ist und durch Abrollen der gerollten Blattfeder (26) dazwischen eine Rotationsbewegung ausführt.

14. Sensor (10) nach einem der vorhergehenden Ansprüche,
der einen Lichtsender (32) umfasst, wobei die Optik (14, 30) als eine dem Lichtsender (32) zugeordnete Sendeoptik (30) ausgebildet ist und/oder der einen Lichtempfänger (16) umfasst, wobei die Optik (14, 30) als eine dem Lichtempfänger (16) zugeordnete Empfangsoptik (30) ausgebildet ist.

15. Verfahren zur Fokusverstellung einer Optik (14, 30) eines optoelektronischen Sensors (10), wobei für eine Einstellung einer Fokuslage ein bewegliches Trägerelement (22) mit der Optik (14, 30) gegenüber einem feststehenden Halteelement (24) seine Position verändert,
**dadurch gekennzeichnet,**
**dass** sich das Trägerelement (22) gegenüber dem Halteelement (24) bewegt, indem eine dazwischen angeordnete gerollte Blattfeder (26) auf- oder abrollt.

## Geänderte Patentansprüche

### Geänderte Patentansprüche gemäss Regel 137(2) EPÜ.

1. Optoelektronischer Sensor (10) mit einer fokusverstellbaren Optik (14, 30), wobei der Sensor (10) ein bewegliches Trägerelement (22) mit der Optik (14, 30), ein feststehendes Halteelement (24) und mindestens eine gerollte Blattfeder (26) aufweist, die zwischen Trägerelement (26) und Halteelement (24) angeordnet ist, wobei das Trägerelement (22) und das Halteelement (24) jeweils eine Fläche (38a-b) aufweisen und wobei für eine Einstellung einer Fokuslage die Position des beweglichen Trägerelements (22) gegenüber dem Halteelement (24) veränderbar ist,
**dadurch gekennzeichnet,**
**dass** die gerollte Blattfeder (26) während einer Bewegung des beweglichen Trägerelements (22) auf den Flächen (38a-b) auf- oder abrollt.

2. Optoelektronischer Sensor (10) nach Anspruch 1,
wobei das Trägerelement (22) mittels der gerollten Blattfeder (26) linear längs der optischen Achse (42) der Optik (14, 30) beweglich gelagert ist.

3. Optoelektronischer Sensor (10) nach Anspruch 1 oder 2,
wobei die gerollte Blattfeder (26) einen Ring bildet.

4. Optoelektronischer Sensor (10) nach Anspruch 3,
wobei das Trägerelement (22) in einer Richtung (20) in der Ebene des Rings beweglich ist.

5. Optoelektronischer Sensor (10) nach einem der vorhergehenden Ansprüche, wobei die gerollte Blattfeder (26) an dem Trägerelement (22) und dem Halteelement (26) fixiert (34) ist.

6. Optoelektronischer Sensor (10) nach einem der vorhergehenden Ansprüche, wobei die gerollte Blattfeder (26) mit ihrer flachen Außenseite an Halteelement (24, 38a) und Trägerelement (22, 38b) gedrückt ist.

7. Optoelektronischer Sensor (10) nach einem der vorhergehenden Ansprüche, wobei die gerollte Blattfeder (26) zwischen Halteelement (24, 38a) und Trägerelement (22, 38b) eingeklemmt ist.

8. Optoelektronischer Sensor (10) nach einem der vorhergehenden Ansprüche, wobei die Flächen (38a-b) eine Kontur aufweisen, um die gerollte Blattfeder (26) mit einer Vorspannung zu beaufschlagen.

9. Optoelektronischer Sensor (10) nach Anspruch 8,
wobei die Kontur Rastpositionen aufweist.

10. Optoelektronischer Sensor (10) nach einem der vorhergehenden Ansprüche, der mindestens zwei Halteelemente (24) und mindestens zwei gerollte Blattfedern (26) aufweist, wobei die Halteelemente (24) zu mindestens zwei Seiten des beweglichen Trägerelements (22) mit jeweils einer gerollten Blattfeder (26) dazwischen angeordnet sind.

11. Optoelektronischer Sensor (10) nach einem der vorhergehenden Ansprüche, wobei das Trägerelement (22) eine ringförmige Außenfläche (38b) und das Halteelement (24) eine ringförmige Innenfläche (38a) aufweist, das Trägerelement (22) konzentrisch in dem Haltelement (24) angeordnet ist und durch Abrollen der gerollten Blattfeder (26) dazwischen eine Rotationsbewegung ausführt.

12. Optoelektronischer Sensor (10) nach einem der vorhergehenden Ansprüche, der einen Lichtsender (32) umfasst, wobei die Optik (14, 30) als eine dem Lichtsender (32) zugeordnete Sendeoptik (30) ausgebildet ist und/oder der einen Lichtempfänger (16) umfasst, wobei die Optik (14, 30) als eine dem Lichtempfänger (16) zugeordnete Empfangsoptik (30) ausgebildet ist.

13. Verfahren zur Fokusverstellung einer Optik (14, 30) eines optoelektronischen Sensors (10), wobei für eine Einstellung einer Fokuslage ein bewegliches Trägerelement (22) mit der Optik (14, 30) gegenüber einem feststehenden Halteelement (24) seine Position verändert, wobei das Trägerelement (22) und das Halteelement (249 jeweils eine Fläche (38a-b) aufweisen,
**dadurch gekennzeichnet,**
**dass** sich das Trägerelement (22) gegenüber dem Halteelement (24) bewegt, indem eine dazwischen angeordnete gerollte Blattfeder (26) auf den Flächen (38a-b) auf- oder abrollt.
